# EUROPEAN PATENT APPLICATION

(11) **EP 4 290 595 A1**
(43) Date of publication of application: **13.12.2023**
(21) Application number: 22178276.6
(22) Date of filing: 10.06.2022
(51) Int. Cl.: H01L 51/00, H01L 51/42

(54) **METHOD OF CRYSTALLIZATION PROCESS CONTROL TO GENERATE "BLACK PHASE" (ALPHA-PHASE) OF FAPBI3-BASED PEROVSKITE**

(71) Applicant: TOYOTA JIDOSHA KABUSHIKI KAISHA, Toyota-shi, Aichi-ken, 471-8571 (JP)
(72) Inventor: KINGE, Sachin, 1140 BRUSSELS (BE); NAZEERUDDIN, Mohammad Khaja, 1024 ECUBLENS (CH); DYSON, Paul Joseph, 1024 ECUBLENS VD (CH); FEI, Zhaofu, 4303 KEISERAUGST (CH); DING, Bin, 1950 SION VS (CH); DING, Yong, 1950 VALAIS (CH)
(74) Representative: Cabinet Beau de Loménie

(57) **Abstract**

The present invention relates to a method for preparing an α-phase FAPbI₃-based perovskite film, wherein FA is formamidinium [CH(NH₂)₂]⁺, comprising the following steps:
(1) preparing a perovskite precursor solution containing (a) perovskite precursors FAI and PbI₂ with a mole ratio FA:Pb of more than 0.85, and preferably from 0.90 to 1.00, and (b) an ionic liquid of formula AB, wherein A is a cationic imidazole derivative in which at least one of the two nitrogen atoms in the imidazole ring is linked to a carbon chain bearing a cyano (-C≡N) group and B is an anion;
(2) spin coating the perovskite precursor solution onto a substrate in an inert atmosphere to prepare a spin coated film;
(3) vacuum drying the spin coated film to form a fresh perovskite film; and
(4) annealing the fresh perovskite film to form the α-phase FAPbI₃-based perovskite film.

## Description

### Technical Field

The present invention concerns an improved method of crystallization of FAPbI₃-based perovskite, and the use of ionic liquids to improve this crystallization.

### Background

A significant gap in efficiency exists between laboratory-scale perovskite solar cells and modules and drags down the commercialization of perovskite solar cell technology. Major issues for inefficient modules are attributed to achieving a dense, uniform and well-crystallized large-area perovskite film.

Non-patent literature reference (1) describes vacuum assisted crystallization of perovskite. Non-patent literature references (2) and (3) describe intermediate phase formation/transformation during perovskite crystallization. Non-patent literature reference (4) describes the influence of Cl⁻on the kinetics of crystallization. Non-patent literature reference (5) describes the influence of an imidazole cation with bi-cyano functional group on the kinetics of crystallization. Non-patent literature reference (6) describes stabilization of black-phase formamidinium lead iodide (α-FAPbI₃) perovskite, regardless of humidity and temperature, based on a vertically aligned lead iodide thin film grown from an ionic liquid, methylamine formate. Non-patent literature reference (7) describes the influence of intermediate phases on the performance/stability of perovskite solar cells.

### Non-patent literature references

(1) Ding, B. et al. Material nucleation/growth competition tuning towards highly reproducible planar perovskite solar cells with efficiency exceeding 20%. J. Mater. Chem. A 5, 6840-6848 (2017).
(2) Gratia, P. et al. The many faces of mixed ion perovskites: unraveling and understanding the crystallization process. Acs Energy Lett. 2, 2686-2693 (2017).
(3) Dang, H. X. et al. Multi-cation synergy suppresses phase segregation in mixed-halide perovskites. Joule 3, 1746-1764 (2019).
(4) Kim, M. et al. Methylammonium chloride induces intermediate phase stabilization for efficient perovskite solar cells. Joule 3, 2179-2192 (2019).
(5) Gao. X.X. et al. Engineering long-term stability into perovskite solar cells via application of a multi-functional TFSI-based ionic liquid. Cell Rep. Phys. Sci. 2, 100475 (2021).
(6) Hui, W. et al. Stabilizing black-phase formamidinium perovskite formation at room temperature and high humidity. Science 371, 1359-1364 (2021).
(7) Lin, Y. H. et al. A piperidinium salt stabilizes efficient metal-halide perovskite solar cells. Science 369, 96-102 (2020).

When the perovskite crystallization process is not under control, it leads to microstructures that are not phase pure and/or contain pinholes and/or contain significant concentrations of crystalline defects in perovskites. All of these microstructural and crystalline defects significantly reduce both the performance and stability of perovskite solar cells. Thus, pinholes lead to short circuits which principally reduce the device fill factor, and the presence of secondary and tertiary phases that are not PV active provide nucleation sites for further crystallographic degradation, particularly in the case of the presence of any humidity. Crystallographic defects decrease the mean free path of charge carriers and thus increase the probability of recombination which reduces the device current and hence negatively affect the overall efficiency.

FAPbI₃-based perovskite suffers from the phase transition from photoactive "black phase" (α-phase) to photo-inactive "yellow phase" (δ-phase), limiting its practical application in conditions of humidity.

It is desirable in this context to achieve a direct transition, in the wet deposited perovskite process, to the desired α-phase material, without passing through the transitions to deleterious intermediate phases of FAPbI₃-based perovskites. This enables the formation of dense, large grained, single phase, and pinhole-free films. The aforementioned characteristics yield very high photovoltaic efficiencies and increase the intrinsic stability of devices made using this chemistry and process methodology. Hence creating α-phase material in a controlled fashion is a key challenge.

### Summary of the Invention

With a view to addressing the problems discussed hereinabove, the present invention, in a first aspect, relates to a method for preparing an α-phase FAPbI₃-based perovskite film, wherein FA is formamidinium [CH(NH₂)₂]⁺, comprising the following steps:
(1) preparing a perovskite precursor solution containing (a) perovskite precursors FAI and PbI₂ with a mole ratio FA:Pb of more than 0.85, and preferably from 0.90 to 1.00, and (b) an ionic liquid of formula AB, wherein A is a cationic imidazole derivative in which at least one of the two nitrogen atoms in the imidazole ring is linked to a carbon chain bearing a cyano (-C≡N) group and B is an anion;
(2) spin coating the perovskite precursor solution onto a substrate in an inert atmosphere to prepare a spin coated film;
(3) vacuum drying the spin coated film to form a fresh perovskite film; and
(4) annealing the fresh perovskite film to form the α-phase FAPbI₃-based perovskite film.

Preferably, in the method of the invention, the anion B of the ionic liquid of formula AB is selected from the group consisting of Cl⁻, Br⁻, I⁻, [SCN]⁻, [TFSI]⁻, [PF₆]⁻ and [BF₄]⁻.

Preferably, in the method of the invention, the quantity of ionic liquid of formula AB added to the perovskite precursors is at most 1.5 mol%, with respect to the number of moles of Pb, and preferably 0.6 to 1.0 mol%. Preferably, the perovskite precursor solution contains methylammonium MA of formula [CH₃-NH₃]⁺ with a mole ratio MA:Pb of at most 0.50, preferably at most 0.30. In some preferred embodiments, a mole ratio MA:Pb of at least 0.20 and at most 0.30, or at most 0.10 and at most 0.20 may be used. In other preferred embodiments, the perovskite precursor solution may contain a mole ratio MA:Pb of at most 0.10, or at most 0.05. Most preferably, methylammonium MA is introduced as the chloride MACI. In a preferred embodiment, the perovskite precursor solution contains caesium Cs, with a mole ratio Cs:Pb of at most 0.10, preferably at most 0.05. In preferred embodiments, equimolar amounts of the precursors FAI and PbI₂ may be used in the perovskite precursor solution, corresponding to a mole ratio FA:Pb of 1.00.

In the method of the invention, the perovskite precursor solution preferably comprises solvents including at least one of: dimethylformamide, dimethyl sulfoxide, γ-butyrolactone and N-Methyl-2-pyrrolidone.

In the method of the invention, spin coating is preferably carried out between 1000 rpm and 5000 rpm for 3 seconds to 50 seconds. In a particularly preferred embodiment, spin coating is carried out at 1000 rpm for 10 seconds, increased to 4000 rpm in 3 seconds and 4000 rpm for 20 seconds.

In the method of the invention, annealing is preferably carried out between 70°C and 150°C for 10 min to 1 hour. In preferred embodiments, annealing is carried out in two steps, a first step at 100°C for 1 h and a second step at 150°C for 10 min.

In another aspect, the present invention relates to the use of an ionic liquid of formula AB, wherein A is a cationic imidazole derivative in which at least one of the two nitrogen atoms in the imidazole ring is linked to a carbon chain bearing a cyano (-C≡N) group and B is an anion, to promote the α-phase in the crystalline structure of an FAPbI₃-based perovskite film. In a particularly preferred embodiment, the ionic liquid of formula AB used has the following structure:

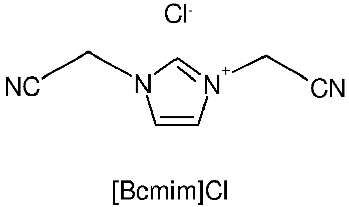

It is intended that combinations of the above-described elements and those within the specification may be made, except where otherwise contradictory.

It is to be understood that both the foregoing general description and the following detailed description are exemplary and explanatory only and are not restrictive of the disclosure, as claimed.

The accompanying drawings, which are incorporated in and constitute a part of this specification, illustrate embodiments of the disclosure and together with the description, serve to explain the principles thereof.

### Brief Description of the Drawings

Figure 1(A) shows XRD patterns of annealed perovskite films with 20 mol% MACI as a function of [Bcmim]CI content. Figure 1(B) shows normalized XRD patterns of annealed perovskite films as a function of the [Bcmim]CI content. Figure 1(C) shows the corresponding (110) peaks in the enlargement of the 2*θ*-angle range from 13.6° to 14.7°.
Figure 2 shows XRD patterns of the perovskite films with different cations of ionic liquids with the concentration of 0.6 mol%. Figure 2(A) shows the structural formulae of ionic liquids, and Figure 2(B) shows XRD patterns of the perovskite films based on these ionic liquids. Here, the lines with FWHM values of, respectively, 0.0764, 0.775, 0.0845 and 0.0823, correspond to the tests: [Bcmim]CI, [Cmmim]CI, [Im]CI, and Control, respectively.
Figure 3 shows XRD patterns of the perovskite films without MACI and [Bcmim]CI (Pristine), with 1.0 mol% [Bcmim]CI ([Bcmim]CI), 20 mol% MACI (MACI), and 20 mol% MACI +1.0 mol% [Bcmim]C (MACl/[Bcmim]Cl).
Figure 4 shows the performance of perovskite solar cells and modules.
Figure 4(A) shows the configuration of the n-i-p PSCs, Figure 4(B) the I-V curves of control and target champion modules under reverse scan with the inserted figure for the stabilized power output, and Figure 4(C) I-V curves of one target solar module measured in Newport.
Figure 5 shows the performance of perovskite solar cells and modules.
Figure 5(A) shows the configuration of the n-i-p PSCs, and Figure 5(B) the cross-sectional SEM image of a typical device.
Figure 6 shows the statistical distributions of photovoltaic parameters as a function of the [Bcmim]CI content, with (A) *J*_{SC}, (B) *V*_{OC}, (C) FF, and (D) PCE.

### Detailed Description

Reference will now be made in detail to exemplary embodiments of the disclosure, examples of which are illustrated in the accompanying drawings. Wherever possible, the same reference numbers will be used throughout the drawings to refer to the same or like parts.

Throughout the description, including the claims, the term "comprising a" should be understood as being synonymous with "comprising at least one" unless otherwise stated. In addition, any range set forth in the description, including the claims should be understood as including its end value(s) unless otherwise stated. Specific values for described elements should be understood to be within accepted manufacturing or industry tolerances known to one of skill in the art, and any use of the terms "substantially" and/or "approximately" and/or "generally" should be understood to mean falling within such accepted tolerances.

Where any standards of national, international, or other standards body are referenced (e.g., ISO, etc.), such references are intended to refer to the standard as defined by the national or international standards body as of the priority date of the present specification. Any subsequent substantive changes to such standards are not intended to modify the scope and/or definitions of the present disclosure and/or claims.

Although the present disclosure herein has been described with reference to particular embodiments, it is to be understood that these embodiments are merely illustrative of the principles and applications of the present disclosure.

It is intended that the specification and examples be considered as exemplary only, with a true scope of the disclosure being indicated by the following claims.

Metal halide perovskite-based photovoltaics are one of the most promising photovoltaic technologies because of their remarkable electronic and optoelectronic properties. However, there is a greater decrease in efficiency when up-scaling PSC devices compared with silicon photovoltaics. This lack of conformity in efficiency arises from the lack of quality of large-area perovskite films with high crystallinity, uniform phase, and few defects.

The term "organic-inorganic hybrid perovskites", hereinafter also referred to as "hybrid perovskites", as used herein, refers to ABX₃ materials with A being organic cation groups such as methylammonium (MA), butylammonium (BA), formamidinium (FA), or the alkali metals Cs or Rb, and their mixtures; B being a metal such as Pb, Sn, Bi, Cu, Ag and their mixtures; and X being halides such as Cl, Br, I and their mixtures. The present invention concerns organic-inorganic hybrid perovskites having lead (Pb) as the metal B and iodide (I) as the halogen X. Combinations of caesium (Cs) metal cation and organic cations such as formamidinium (FA) and/or methylammonium (MA) may be used, and a particularly preferred cation system is the triple cation system Cs-FA-MA (with FA as the dominant component in molar terms).

The structures of FA and MA are as follows:

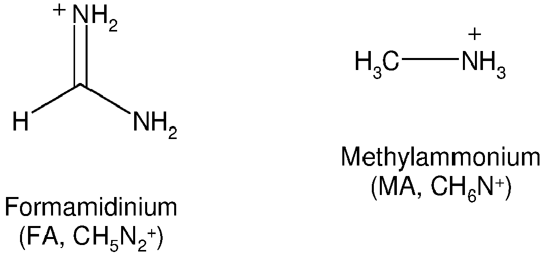

Compared with MA-based perovskites, FA-based perovskites have been widely investigated due to their admissible thermal stability and favorable bandgap, close to the ideal bandgap of the Shockley-Quesser optimum, thus enabling the achievement of record solar-to-electricity efficiencies. However, pure FAPbI₃-based perovskite suffers from the phase transition from photoactive "black phase" (α-phase) to photo-inactive "yellow phase" (δ-phase), limiting its practical application in humid environments. In this context, the following has been observed:
(1) Doping cations (MA⁺, Cs⁺, Rb⁺) or anions (Br⁻, Cl⁻, SCN⁻, or HCOO⁻) into the FAPbI₃ lattice may stabilize the α-phase, but the bandgap of the resulting materials is relatively large, resulting in inefficient light absorption.
(2) Instead, co-doping MA and Cs⁺ into the lattice seems plausible for stable and highly efficient devices, because doping MA can achieve an appropriate bandgap and incorporating Cs will retard the formation of δ-phase in the crystallization process. However, mixed cations of perovskites make it difficult to control their crystallization process and obtain high-quality perovskite films.
(3) Incorporating MACI into the perovskite precursor was proven to be an effective approach to form an intermediate product with pure α-phase and stabilize its structure via cationic site substitution. However, adding too much MACI produces too many pinholes in the perovskite film as a result of the massive release of gaseous MACI during the annealing process, and further indicates that there still exists a small amount of solvent phases and δ-phase in the perovskite during the crystallization process. Moreover, the side effect of the δ-phase is inevitably enlarged in the upscaling perovskite films, resulting in large-scale perovskite films with bad reproducibility and inferior performance of modules. Therefore, it is desirable to develop an easier approach to control the crystallization process for avoiding the formation of the δ-phase and directly converting it into α-phase without annealing.

In the present invention, it is possible to achieve slowing of the crystallization process via the introduction of ionic liquid additive for the stabilization of α-phase FAPbI₃ films. The ionic liquid is composed of imidiazole-based cation with at least one cyano functional group and Cl⁻, Br⁻, I⁻, BF₄⁻, PF₆⁻, or TFSI⁻-based anion. The ionic liquid-modified FAPbI₃ film shows high crystallization and charge carrier mobility, low trap densities and suppressed phase segregation. The process of the invention, preferably applied in combination in specific concentration ranges, from 0.3% to 2.0% as a molar percentage of imidiazole-based cation with respect to lead (Pb), and when combined with vacuum-assisted drying, and appropriate post-drying thermal treatments, leads to homogeneous large area α-phase perovskite films with exceptional performance. The addition of laser derived series interconnects allows for the production of large scale devices with performances exceeding 20%. More complex interactions between these imperfections generally lead to decreased device performance and stability.

The ionic liquids used in the present invention are salts of a cationic imidazole derivative in which at least one of the two nitrogen atoms in the imidazole ring is linked to a carbon chain bearing a cyano (-C≡N) group.

Salts of ionic liquid imidazolium species with many types of N-borne side chain are widely used notably as solvents in catalytic reactions, and in electrochemical applications. They are prepared and available not only with halide (such as chloride, bromide and iodide) anion counterions, but also with nitrate or acetate, dicyanamide, or fluorinated anions such as BF₄⁻, PF₆⁻, trifluoromethane sulfonate, bis(trifluoromethyl sulfonyl)imide etc.

Imidazolium salts [C1CNmim]Cl, [C3CNmim]CI and [(C3CN)₂im]Cl are all commercially available, for example from the suppliers Sigma-Aldrich, Alfa Chemistry, ABClabtory Scientific, and have the following structures:

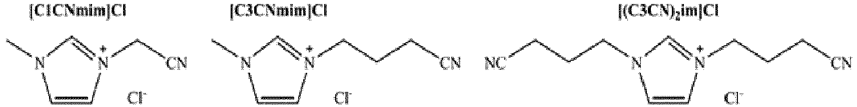

Methods of synthesis of [C1CNmim]Cl and [C3CNmim]CI have further been described in Zhao et al., Inorg. Chem. 2004, 43, 6, 2197-2205, and for [(C3CN)₂im]Cl in Zhao et al., Chem. Commun., 2004, 2500-2501. As a further example of interest, [C4CNmim]CI is commercially available from Chemieliva Pharmaceutical, and its synthesis is described in Zhao et al., Inorg. Chem. 2004, 43, 6, 2197-2205.

In the present invention, preferred ionic liquids are ones containing the following cyano-alkyl group-bearing imidazolium salts, in particular added as chloride salts:

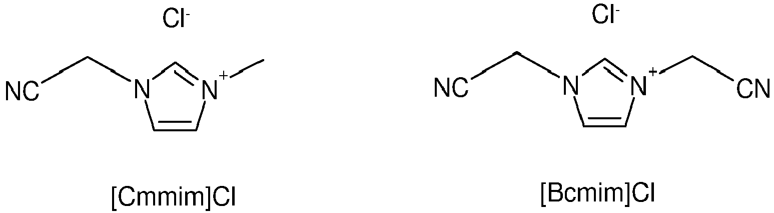

[Cmmim]⁺ is thus 1-cyanomethyl-3-methylimidazolium, and the structure may be drawn with a positive charge on either of the two nitrogen atoms. [Bcmim]⁺ is 1,3-bis(cyano-methyl) imidazolium, and is a particularly preferred cationic imidazole derivative in the present invention, appropriately introduced as a chloride salt.

In a preferred embodiment, a precursor solution may be prepared containing both perovskite precursors FA and PbI₂, and preferably MACI supplementary precursor, preferably in a mixed solvent in particular based on dimethylformamide and dimethyl sulfoxide, and separately an ionic liquid solution may be prepared in a solvent such as dimethyl sulfoxide, based on [Bcmim]⁺ or [Cmmim]⁺ in combination with an anion such as Cl⁻, Br⁻, I⁻, [SCN]⁻, [TFSI]⁻, [PF₆]⁻ or [BF₄]⁻, and then the precursor solution and ionic liquid solution may be combined to provide the final perovskite precursor solution to be used for spin coating. Where a mixed solvent of DMF:DMSO is used, a ratio of dimethylformamide and dimethyl sulfoxide of between 4:20 v/v and 4:1 v/v is preferable.

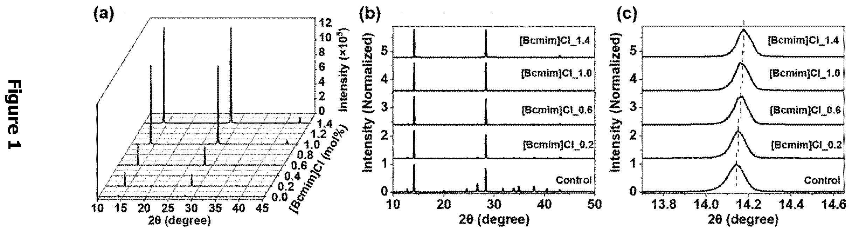

In the experimental work of the present invention, the influence of [Bcmim]CI on the perovskite crystallinity has been observed in detail following the addition of different contents (0, 0.2, 0.6, 1.0, to 1.4 mol%) of the [Bcmim]CI, added into the perovskite precursor and labeled as "Control", "[Bcmim]Cl_0.2", "[Bcmim]Cl_0.6", "[Bcmim]Cl_1.0", and "[Bcmim]Cl_1.4", respectively. As found in XRD patterns (Figure 1a), all the perovskite films show similar diffraction peaks, but their intensity increased dramatically with doping the [Bcmim]CI, indicating that the [Bcmim]CI addition does not enter into the crystal lattice, but promotes the crystallization of the perovskite films.

Notably, compared with the Control film, the (110) peak of the [Bcmim]CI-based perovskites is slightly shifted to larger angles with increasing the [Bcmim]CI doping (Figure 1 b and c), which might be attributed to the stabilized MA component in the perovskite by the [Bcmim]CI under high temperatures. The stabilized perovskite phase is further confirmed by the decreased content of PbI₂ in the perovskite and a blue shift of UV-vis absorption edge with the increased ratio of the [Bcmim]CI.

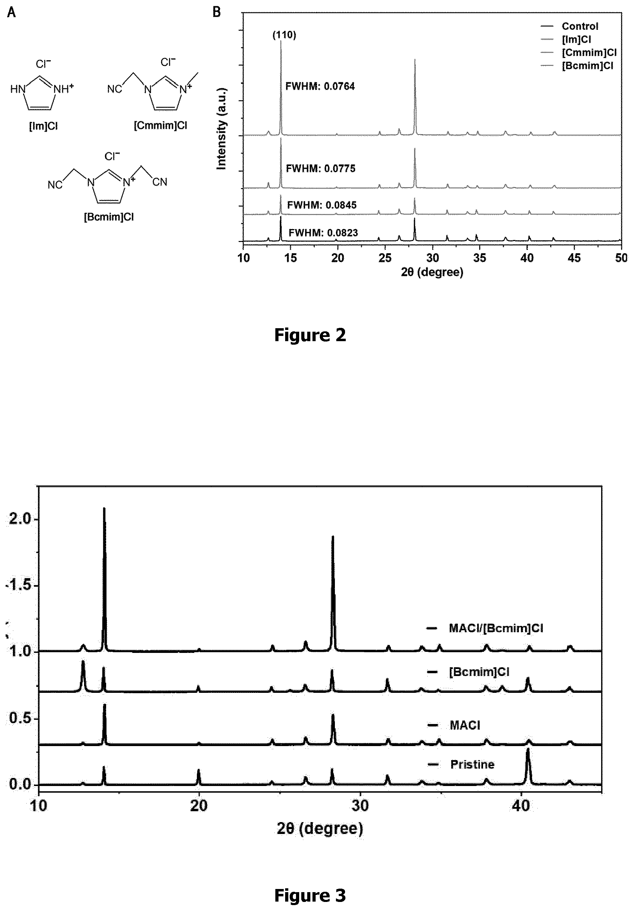

To determine which part of [Bcmim]CI (imidazole group, cyano group or Cl⁻ anion) has an influence, the present inventors compared 1-cyanomethyl-3-methylimidazolium chloride ([Cmmim]CI) and imidazolium chloride ([IM]CI) (Figure 2a), and found that the number of cyano groups affects the crystallinity of the perovskite films. It is thus observed that the greater the number of the cyano groups, the higher the crystallinity. Apart from the role of cyano groups, the Cl⁻ anion has also effect on the crystallinity (Figure 2b). If only the MACI or [Bcmim]CI is incorporated into the perovskite, the intensity of the MACI- and the [Bcmim]CI-based perovskite films shows little increased intensity (Figure 3). Combination of the MACI with the [Bcmim]CI can promote the crystal growth and enhance the crystallinity, indicating a synergistic effect between the [Bcmim]Cl and the MACI.

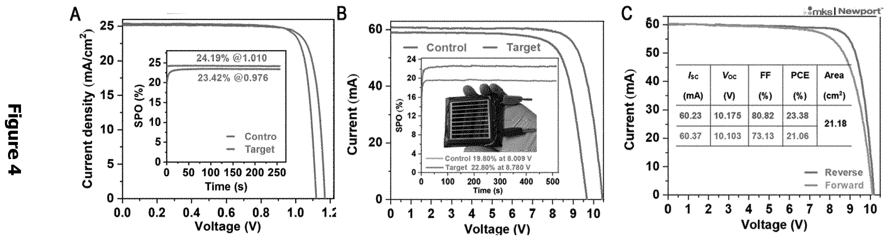

The [Bcmim]CI-based perovskite films show strong uniform photoluminescence intensity, reduced trap-state density, and high charge carrier mobility, which lowers trap-assisted non-radiative recombination and achieves a low voltage deficit. The resulting small-size devices and modules attain a PCE of 24.38% (Figure 4a) (certified 24.0%, Newport) and 23.11% (Figure 4b) (23.38%, measured at Newport) (Figure 4c), respectively, and this is the smallest efficiency gap between small-area devices and modules. Moreover, the [Bcmim]CI-based devices have long-term operational stability with 95% of its initial efficiency and thermal stability with 83% of its initial efficiency for 1,000 h.

It was thus observed that the ionic liquid [Bcmim]CI, 1,3-bis(cyano-methyl)imidazolium chloride ([Bcmim]CI), when introduced into a perovskite precursor, was able to control the phase transition from intermediate films without annealing to perovskite films for improving the crystallinity and reproducibility of large-scale perovskite films. It is considered that the [Bcmim]Cl may react with PbI₂ in a 1:1 molar ratio to generate a one-dimensional (1D) [Bcmim]₄Pb₃Cl₂I₆ composition. With the presence of MAI (or FAI), it is considered that this reaction may give rise to [Bcmim]PbI₃, which will promote crystallization process and produce high-quality perovskite films. In addition, the electron donating group CN in the ionic liquid further coordinates with the Pb in perovskites providing them with exceptional stability. The [Bcmim]CI-based additive is however not expected to survive the annealing process. The imidazolium-based ionic liquid acts here, preferably with co-presence of MACI, to influence nucleation and grain growth of the primary FAPBI₃ species, a transient aid to crystallization that will then disappear / volatilize.

### <Perovskite solar cell>

A perovskite solar cell, such as may be prepared using the perovskite film or layer of the present invention as set out above, may comprise the following layers:
(a) a transparent conducting layer;
(c) a perovskite layer;
(e) an electrode layer

Preferably, the perovskite solar cell can further comprise one or more of: (b) an electron transport layer; (b') an electron-blocking layer; (d) a hole transport layer; and (d') a hole-blocking layer.

The presence of at least one of these layers leads to a higher device efficiency.

The above-mentioned three layers can be disposed in the order of appearance above. Further, an electron transport layer can be situated between the transparent conducting layer and the perovskite layer, and a hole transport layer can be situated between the perovskite layer and an electrode layer.

In one embodiment, the perovskite solar cell may have a conventional n-i-p structure comprising a transparent conducting layer, an electron transport later, a perovskite layer, a hole transport layer and an electrode layer in this order.

In another embodiment, the perovskite solar cell may have an inverted p-i-n structure comprising a transparent conducting layer, a hole transport later, a perovskite layer, an electron transport layer and an electrode layer in this order.

In still another embodiment, the perovskite solar cell can further comprise mesoporous scaffold, in the perovskite layer.

Generally, in the so-called p-i-n or n-i-p structures, the electron (n) or hole (p) blocking layers are situated in the bottom and top of the perovskite layer (i), in a sandwich configuration, with the perovskite layer (i) being in the middle. A mesoporous TiO₂ layer is usually an electron transport layer (in the n side), but it can also be a hole transport layer (p side).

### <(a) Transparent conductive layer>

A transparent conductive layer is not particularly limited and can comprise or consist of, for example, a fluorine-doped tin oxide (FTO), indium tin oxide (ITO), doped zinc oxide, carbon nanotube networks or graphene, and preferably an FTO.

### <(b) Electron transport layer (ETL)>

The electron transport layer is not particularly limited and can comprise or consist of, for example, TiO₂, SnO₂, Nb-doped SnO₂, Sb-doped SnO₂, C60 and C60 derivatives, bathocuproine (BCP), a combination of C60/BCP, and a combination of TiO_{2/}SnO₂ bilayer.

Among these materials, a combination of TiO_{2/}SnO₂ layer is preferred for n-i-p configuration, and a combination of C60/BCP is preferred for p-i-n configuration.

### <(b') Hole-blocking layer>

An optional hole blocking layer can be, for example, 2,9-dimethyl-4, 7-diphenylphenanthroline (BCP), TiO₂, ZnO.

When the electron transport layer (ETL) material is TiO₂, TiO₂ behaves as both electron transport and hole blocking, given that the layer is compact. However if the ETL material is mesoporous, the perovskite solution infiltrates and touches the FTO electrode (which will produce losses). In order to avoid the direct contact between perovskite and FTO when the ETL material is mesoporous, typically a compact layer of TiO₂ may be advantageously incorporated between FTO and mesoporous-TiO₂ (blocking layer).

### <(d') Electron-blocking layer>

An optional electron blocking layer can be, for example, AIGaN.

### <(d) Hole transport layer>

The hole transport layer is not particularly limited, and can comprise of consist of, for example, spiro-OMeTAD (2,2',7,7'-tetrakis-(N,N'-di-p-methoxyphenylamine)-9,9'-spirobifluorene), pyrene-based materials (such as PY-1, PY-2, PY-3), Truxene-core based materials, phenothiazine-based materials, acridine-, thiophene-, biphenyl-, bithiophene-, tetrathiophene-, difluorobenzene and phenyl-based materials, triazine-based materials, benzotrithiophene- and squaraine-based materials, fluorine- and spiro-fluorene-based materials and carbazole-based materials, phthalocyanines, carbon, metal complexes, CuNCS, NiOₓ, and preferably spiro-OMeTAD.

### <(e) Electrode layer>

The electrode layer is not particularly limited and can comprise or consist of, for example, Au, C, Ag, Cu or Al. Among these, Au is preferred in the laboratory scale since it is very efficient but expensive. For industrial applications, carbon and Cu are preferred.

If the electron-blocking layer material is NiOx, it can be prepared from spin-coating a precursor solution and then thermal annealing.

### Examples

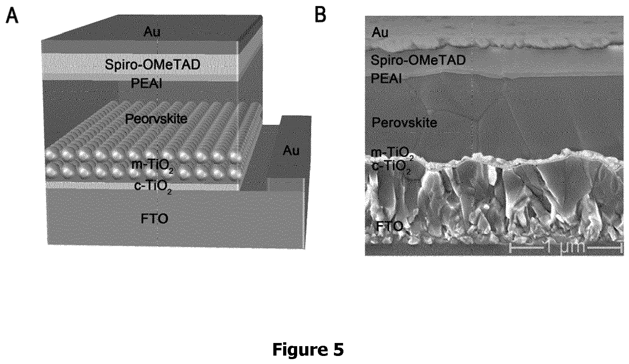

In the experimental studies of the present invention, n-i-p structured devices comprising FTO/compact TiO₂ (c-TiO₂)/mesoporous TiO₂ (m-TiO₂)/Cs_{0.05}MA_{0.05}FA_{0.9}PbI₃/phenylethylamine iodide (PEAI)/Spiro-OMeTAD/Au were fabricated (Figure 5a).

The thickness of the c-TiO_{2/}m-TiO₂ layers was about 100 nm, capped with about 700 nm of the appropriate perovskite film, about 20 nm of PEAI, 220 nm of Spiro-OMeTAD as a hole transporting layer (HTL) and 70 nm of Au as an electrode (Figure 5b).

### Preparation of FAPbI₃ perovskite

A precursor solution was prepared by mixing CsCI (0.065 M), MAI (0.065 M), FAI (1.235 M), PbI₂ (1.235 M) and MACI (0.26 M) into a mixed solvent of DMF (dimethylformamide) and DMSO (dimethyl sulfoxide) (4:1 v/v). The solution was then stirred for 1 h at 60 °C. The perovskite precursor solution was spin-coated onto the surface of the substrate at 1000 rpm for 10 s, accelerated to 4000 rpm for 3 s and maintained at this speed for 20 s. This process was carried out in an N₂ filled glove box. Then, the substrate was placed in a purpose built rapid vacuum drying equipment. After pumping for 20 s, a brown, somewhat transparent perovskite film with a mirror-like surface was obtained. The fresh perovskite layer was annealed at 100 °C for 1 h and then at 150 °C for 10 min.

### Preparation of FAPbI₃ perovskite with [Bcmim]Cl

A control precursor solution was prepared by mixing CsCI (0.065 M), MAI (0.065 M), FAI (1.235 M), PbI₂ (1.235 M) and MACI (0.26 M) into a mixed solvent of DMF (Dimethylformamide) and DMSO (Dimethyl sulfoxide) (4:1 v/v). The solution was then stirred for 1 h at 60 °C. 94.95 mg of [Bcmim]CI was dissolved into 1.0 mL of DMSO to make a stock solution (concentration around 0.52 M). The perovskite solutions with 0.2 mol%, 0.6 mol%, 1.0 mol% and 1.4 mol% [Bcmim]Cl were prepared by mixing 1200 µL of control perovskite solution with 5 µL, 15 µL, 25 µL, and 35 µL of [Bcmim]Cl stock solution (denoted as [Bcmim]Cl_0.2, [Bcmim]Cl_0.6, [Bcmim]Cl_1.0, and [Bcmim]Cl_1.4, respectively). The perovskite precursor solution was spin-coated onto the surface of the substrate at 1000 rpm for 10 s, accelerated to 4000 rpm for 3s and maintained at this speed for 20 s. This process was carried out in an N₂ filled glove box. Then, the substrate was placed in a purpose built rapid vacuum drying equipment. After pumping for 20 s, a brown, somewhat transparent perovskite film with a mirror-like surface was obtained. The fresh perovskite layer was annealed at 100 °C for 1 h and then at 150 °C for 10 min.

### Observations

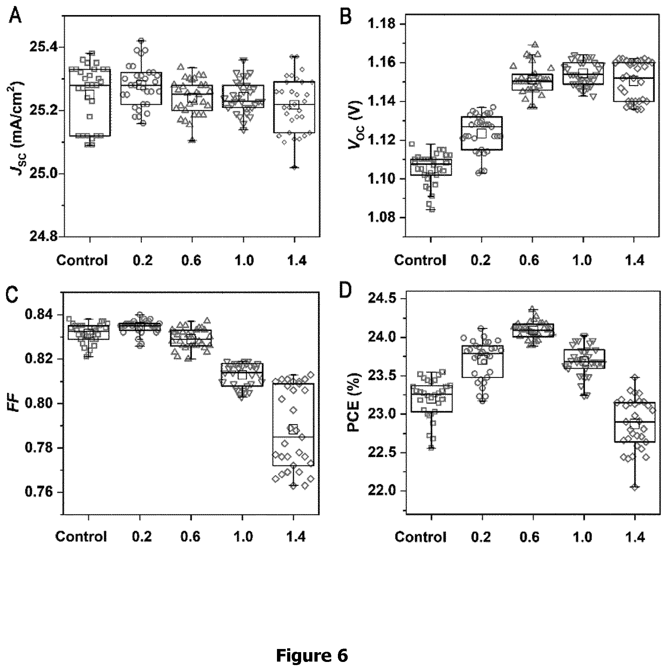

The short-circuit current density (*J*_{SC}) of the ionic liquid ([Bcmim]CI) based devices is slightly decreased at a higher content of [Bcmim]CI, which could be ascribed to the increased bandgap of the perovskite films (Figure 6a). However, the open-circuit photovoltage (*V*_{OC}) of the [Bcmim]CI-based devices shows much improvement compared with that of the Control devices and keeps on increasing upon increasing the [Bcmim]CI ratio (below 1.0 mol%), which may be due to the increased crystallinity and decreased trap densities, resulting in suppression of trap-assisted carrier recombination (Figure 6b).

However, the fill factor (FF) increases at a low content of the [Bcmim]CI, but decreases at higher concentrations, possibly due to a balance between the enhanced conductivity of perovskite films and the barrier effect of [Bcmim]Cl at the surface and grain boundaries (Figure 6c). However, too much [Bcmim]Cl (more than 1.0 mol%) shows a strong barrier effect for charge carriers and thus largely sacrifices the FF. With 0.6 mol% ionic liquid, the device shows much better power conversion efficiency (PCE) than that under control conditions (Figure 6d).

As may be observed in Figure 3, [Cmmim]CI and [Bcmim]CI doping may drastically enhance the crystallinity of the perovskite films as verified by the increased peak intensity and reduced FWHM values of (110) facet, whereas the [Im]Cl exhibits an adverse effect on the crystallinity of the perovskite film. Overall, the [Bcmim]CI-modified perovskite film shows the highest crystallinity.

## Claims

1. Method for preparing an α-phase FAPbI₃-based perovskite film, wherein FA is formamidinium [CH(NH₂)₂]⁺, comprising the following steps:
(1) preparing a perovskite precursor solution containing (a) perovskite precursors FAI and PbI₂ with a mole ratio FA:Pb of more than 0.85, and preferably from 0.90 to 1.00, and (b) an ionic liquid of formula AB, wherein A is a cationic imidazole derivative in which at least one of the two nitrogen atoms in the imidazole ring is linked to a carbon chain bearing a cyano (-C≡N) group and B is an anion;
(2) spin coating the perovskite precursor solution onto a substrate in an inert atmosphere to prepare a spin coated film;
(3) vacuum drying the spin coated film to form a fresh perovskite film; and
(4) annealing the fresh perovskite film to form the α-phase FAPbI₃-based perovskite film.

2. Method according to claim 1, wherein the anion B of the ionic liquid of formula AB is selected from the group consisting of Cl⁻, Br⁻, I⁻, [SCN]⁻, [TFSI]⁻, [PF₆]⁻ and [BF₄]⁻.

3. Method according to claim 1 or 2, wherein the ionic liquid AB is at least one of the two following species:

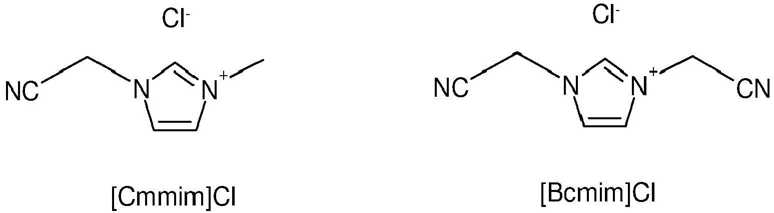

4. Method according to claim 3, wherein the ionic liquid AB is [Bcmim]CI.

5. Method according to any of claims 1 to 4, wherein the quantity of ionic liquid of formula AB added to the perovskite precursors is at most 1.5 mol%, with respect to the number of moles of Pb, and preferably 0.6 to 1.0 mol%.

6. Method according to any of claims 1 to 5, wherein the perovskite precursor solution contains methylammonium MA of formula [CH₃-NH₃]⁺ with a mole ratio MA:Pb of at most 0.50, preferably at most 0.30.

7. Method according to claim 6, wherein methylammonium MA is introduced as the chloride MACI.

8. Method according to any of claims 1 to 7, wherein the perovskite precursor solution contains caesium Cs, with a mole ratio Cs:Pb of at most 0.10, preferably at most 0.05.

9. Method according to any of claims 1 to 8, wherein the perovskite precursor solution comprises solvents including at least one of: dimethylformamide, dimethyl sulfoxide, γ-butyrolactone and N-Methyl-2-pyrrolidone.

10. The method according to any of claims 1 to 9, wherein spin coating is carried out between 1000 rpm and 5000 rpm for 3 seconds to 50 seconds.

11. The method according to claim 10, spin coating is carried out at 1000 rpm for 10 seconds, increased to 4000 rpm in 3 seconds and 4000 rpm for 20 seconds.

12. The method according to any of claims 1 to 11, wherein annealing is carried out between 70°C and 150°C for 10 min to 1 hour.

13. The method according to claim 12, wherein annealing is carried out in two steps, a first step at 100°C for 1 h and a second step at 150°C for 10 min.

14. Use of an ionic liquid of formula AB, wherein A is a cationic imidazole derivative in which at least one of the two nitrogen atoms in the imidazole ring is linked to a carbon chain bearing a cyano (-C≡N) group and B is an anion, to promote the α-phase in the crystalline structure of an FAPbI₃-based perovskite film.

15. Use according to claim 14, wherein the ionic liquid of formula AB is:
